# EUROPEAN PATENT APPLICATION

(11) **EP 3 840 071 A1**
(43) Date of publication of application: **23.06.2021**
(21) Application number: 19218171.7
(22) Date of filing: 19.12.2019
(51) Int. Cl.: H01L 39/14, H01L 39/24

(54) **METHOD FOR MANUFACTURING OF A HIGH TEMPERATURE SUPERCONDUCTOR TAPE**

(71) Applicant: Bruker HTS GmbH, 63450 Hanau (DE)
(72) Inventor: Usoskin, Alexander, 63456 Hanau (DE); Betz, Ulrich, 63755 Alzenau (DE); Schlenga, Klaus, 76149 Karlsruhe (DE)
(74) Representative: Kohler Schmid Möbus Patentanwälte

(57) **Abstract**

A method for manufacturing a high temperature superconductor (=HTS) tape (1), comprising
depositing at least a layer (4) of a first HTS material (4a) and a layer (6, 8) of a second HTS material (6a) on a substrate tape (2),
is characterized in
that the first HTS material (4a) is deposited with the layer (4) of the first HTS material (4a) exhibiting an incomplete connectivity with respect to said layer's superconducting electrical conductivity along the HTS tape (1) length,
and that the second HTS material (6a) is deposited such that the layer (6, 8) of the second HTS material (6a) exhibits a continuous connectivity with respect to said layer's superconducting electrical conductivity along the HTS tape (1) length. The invention provides a method for manufacturing a HTS tape that may achieve an increased critical electric current under high B, low T conditions.

## Description

The invention relates to a method for manufacturing a high temperature superconductor (=HTS) tape, comprising
depositing at least a layer of a first HTS material and a layer of a second HTS material on a substrate tape.

Such a method is known from EP 3 474 296 A1.

Superconductors may carry an electric current at practically no ohmic losses. Superconductors are, for example, used to generate magnetic fields of high strength, for example for use in nuclear magnetic resonance (=NMR) applications. To assume superconductivity, superconductors have to be exposed to cryogenic temperatures, though, since superconductivity is only assumed below a critical temperature Tc, which is specific for the superconductor material.

So called high temperature superconductors (HTS) have, as compared to conventional metallic low temperature superconductors (=LTS), a higher critical temperature Tc, typically with Tc>30K, and often Tc>77K. Accordingly, HTS can often be cooled with inexpensive liquid nitrogen; however, then the critical electric current that may be carried superconductingly is relatively low. When operated at low temperatures such as at 4.2 K, though, HTS exhibit very high critical currents. It should also be noted that superconductivity is lost if the magnetic field is above a critical magnetic field. Due to their brittle ceramic nature, HTS are typically provided in tape form, with a flexible (metallic) substrate and a layer of HTS material deposited on the substrate.

HTS tapes may be optimized for specific applications, for example high B/low T (high magnetic field, low temperature) applications, e.g. B≥15T and T≤4.2K, or on the other hand low B/high T applications, e.g. with B<1 Tesla such as self field and T=77K.

For achieving particularly high critical electric currents under high B/low T conditions, it has been found useful to grow HTS layers with a content of an additive substance (also called "dopant"). For example, the HTS layers of YBCO may be grown with a content of BaZrO₃, in order to increase the critical current. The HTS layer grows with columns of BaZrO₃, which can be seen under TEM investigation, and said columns are assumed to act as artificial pinning rods. However, it has been found that the measured critical current increases with higher concentration of BaZrO₃ as long as the absolute concentration is relatively low, but for high absolute concentrations, the measured critical current decreases again with higher concentration of BaZrO₃, and the BaZrO₃ columns can no more be seen under TEM, compare S.H. Wee et al., Scientific Reports 3:2310 (2013), DOI:10.1038/srep02310.

For low B/high T conditions, it has been found preferable not to introduce "disorder" into the HTS material, but rather avoid defects, in order to obtain a good current carrying capacity.

EP 3 474 296 A1 discloses an oxide superconductor wire, wherein on a substrate, a dense zone, a sparse zone, and a dense zone have been deposited, with the dense zone having a high density of artificial pinning rods, and the sparse zone having a low degree of artificial pinning rods. The dense zones are deposited with a target containing artificial pin material, and the sparse zone is deposited with a target not containing any artificial pin material.

Further HTS tapes comprising two or more different HTS layers are known from CN 105 648 401 A, CN 106 229 404 A or EP 1 925 040 B1. YBCO tapes with columnar defects are also known from US 8,536,098 B2.

### Object of the invention

It is the object of the present invention to provide a method for manufacturing a HTS tape that may achieve an increased critical electric current under high B/low T conditions.

### Short description of the invention

This object is achieved, in accordance with the invention, by a method as introduced in the beginning, characterized in
that the first HTS material is deposited with the layer of the first HTS material exhibiting an incomplete connectivity with respect to said layer's superconducting electrical conductivity along the HTS tape length,
and that the second HTS material is deposited such that the layer of the second HTS material exhibits a continuous connectivity with respect to said layer's superconducting electrical conductivity along the HTS tape length.

The invention proposes to combine a layer of a first HTS material having an incomplete connectivity and a layer of a second HTS material having a continuous connectivity to achieve a superior performance of the overall HTS tape. By accepting an incomplete connectivity in the first HTS material, a superior local critical current density of the first HTS material can be achieved, which can be accessed for long distance applications through the combination with the layer of the second HTS material having continuous connectivity.

The incomplete connectivity (or fragmentary connectivity) of the layer of the first HTS material manifests in a local critical current density (measured in long direction of the tape along a short tape length, such as along a length that equals to 50% of the tape width or less) being much larger (e.g. at least 2 times larger, often at least 5 times larger, or even at least 50 times larger) than a long distance critical current density (measured in long direction of the tape along a long tape length, such as a length that equals 100 times the tape width or more); often the long distance critical current density breaks down practically completely.

In contrast, the continuous connectivity of the layer of the second HTS material manifests in the local critical current density being about the same as the long distance critical current density (e.g. differing by a factor of 1.5 or less, or even by a factor of 1.2 or less).

Note that for determining the connectivity, the temperature and the magnetic field are of some, but minor influence; in according with the invention, the connectivity can be determined at 4.2 K and at 18 Tesla (low T/high B conditions).

The inventors found that when applying high doping levels to an HTS material, or otherwise introducing a high level of disorder into an HTS material, it is typically only the *long distance* critical current density that drops with growing disorder under high B/low T conditions. In contrast, the *local* critical current density under high B/low T conditions may be further increased with growing disorder at high doping or disorder levels under high B/low T conditions. In other words, when applying a high level of doping or disorder to an HTS material, the HTS material exhibits what is called here an incomplete connectivity. In the state of the art, where typically only a long distance critical current was measured, simply a drop in critical current was observed with higher doping levels, and the HTS material was considered useless.

However, in accordance with the invention, by combining a layer of HTS material of incomplete connectivity (first HTS material) with a layer of HTS material of continuous connectivity (second HTS material), the overall tape may carry very high critical currents over long distance under low T/high B conditions, using to a far extent the (relatively high) local critical current density of the first HTS material. The second HTS material may "bridge" the missing connections within the first HTS material superconductingly, while limiting the critical current density only to a low extent, if at all.

The inventors found that a surprisingly high efficiency of this "bridging" could be achieved. The bridging effect depends on the level of interchange of currents between the different HTS layers. A particularly efficient bridging effect, practically without dissipative losses, could be achieved when establishing a large contacting surface of the layers of first HTS material and second HTS material, in particular by using both sides of the layer of the first HTS material for current exchange, and by establishing a direct contact between the layers of first HTS material and second HTS material, i.e. in the absence of additional interlayers between these layers. This is valid also in case of island / fragmentary structure of the layer of first HTS material. The bridging effect could be improved by "inter-penetration" (or inter-intruding) of the layers of first HTS material and second HTS material, in particular by filling up gaps between islands of first HTS material with second HTS material. The two materials may behave as "complementary" ones with respect to their type of conductivity, with their combination allowing a significant improvement of the overall HTS tape performance under low T/high B conditions.

Note that in general, also a satisfactory critical current transport capacity of the overall HTS tape can be achieved under high T/low B conditions (at 77 K and self magnetic field), too, so the HTS tape can be used universally under different conditions.

The first HTS material contains, in general, a much higher level of disorder than the second HTS material. Disorder may be introduced as "extrinsic disorder", i.e. by additive material different from the (first or second) HTS material, and/or as "intrinsic disorder", i.e. by deviations from the correct (local) lattice structure in the HTS material or its crystals, respectively, originating for example from non-ordered (extra) atoms and vacancies, resulting in a locally incorrect chemical balance, or generally a disturbed lattice structure. Introducing a high level of extrinsic and/or intrinsic disorder in the layer of first HTS material (in particular higher as compared to the layer of second HTS material) in general leads to a concentration of pinning centers (formation of new pinning centers) in the layer of first HTS material (in particular a higher concentration of pinning centers as compared to the layer of second HTS material). The concentration of pinning centers in the first HTS material improves the local critical current density under low T, high B conditions. However, the concentration of pinning centers (formation of new pinning centers) by introducing a high level of disorder comes along with said incomplete connectivity.

Often, the first HTS material shows an island type (fragmentary) structure, and the second HTS material fills in the gaps between the islands (fragmented substructures). Further, high doping levels in the first material often lead to precipitates of the additive substance (material) becoming smaller and more numerous (i.e. finer distributed), what may help to improve the local critical current density under low T, high B conditions by means of more numerous pinning centers. On the other hand, the (local) critical current density under high T, low B conditions drops then. High levels of intrinsic disorder make the fraction "non-ordered" atoms and/or local deviations of the stoichiometry more numerous, what likewise makes pinning centers more numerous, with this having an analogous effect on the current carrying characteristics of the first HTS material.

The first HTS material and the second HTS material are typically based on the same type of HTS material, with a different degree of disorder, which may be based on extrinsic and/or intrinsic disorder. The first and second HTS materials are typically of ReBCO type (Re=rare earth element), in particular comprising YBCO, or BSCCO type. The first and second HTS material typically have a critical temperature Tc with Tc>77K; note that if Tc is < 77K, then high T conditions should not be chosen at 77 K, but at a temperature somewhat below Tc, e.g. at 30 K. The substrate tape material is typically made of a flexible metal, e.g. from stainless steel or Hastelloy.

Note that when referring to high T/low B conditions here, corresponding measurements may be done at 77K / self magnetic field. When referring to low T/high B conditions here, corresponding measurements may be done at 4.2 K / 18 Tesla.

### Preferred variants of the invention

In a preferred variant of the inventive method, at least the first HTS material is deposited with a content of an additive substance,
and the content of the additive substance in the first HTS material is chosen high level such that it contributes to or results in concentration of pinning centers and said incomplete connectivity. The content of additive substance is chosen high enough such that the additive substance generates extrinsic disorder, which may provide pinning centers which increase the critical current density at high field, low temperature conditions, but comes along with the incomplete connectivity of the layer of first HTS material. The additional substance is different from the first HTS material, and the additive substance and the first HTS material generally originate from different source materials (e.g. PLD targets) or different components within a source material (such as a PLD target). In order to control the additive substance content in the first and/or second HTS layer, the deposition contributions of different source materials and/or the content of additive substance (or its precursor or precursors) within a respective source material can be adjusted. Moreover, deposition conditions may be adjusted, in particular varied, in order to influence a resulting additive substance content in the first and/or second HTS layer. A typical additive substance for the invention is BaZrO₃. Nevertheless alternative additive substances can be employed as, for example, Y₂O₃, Gd₂O₃, BaHfO₃, BaSnO₃, Ba₂YNbO₆, Ba₂YTaO₆, etc. or their combinations. A typical additive substance content in the first HTS material is 3 wt% or more, preferably 6 wt% or more. A typical additive substance content of the second HTS material is less than 2 wt%, often less than 1 wt%. Typically, the first HTS material has a much larger content of the additive substance than the second HTS material, e.g. by a factor of at least 3, or by a factor of at least 6. The second HTS material may even be free of additive substance.

In a preferred further development of this variant, depositing of the first HTS material is done with suppressing the formation of macro-scale structures of the additive substance, in particular of nano-rods of the additive substance, within the layer of the first HTS material. When macro-scale structures (i.e. structures having a size which is comparable to the thickness/height of the layer of the first HTS material or larger) of the additive substance are avoided, it has been found that the local critical current density within the first HTS material can in general be increased. When macro-scale structures are avoided, this possibly enhances the formation of smaller, in particular spot-sized pinning centers, which can increase very efficiently the local critical current density under low T, high B conditions. Often, choosing the content of additive substance in the first HTS material high enough can suppress the formation of macro-scale structures; it may also be helpful to disturb the growth process e.g. by electromagnetic beams or particle beams such as ion or neutron beams, see e.g. M. Chudy et al, (2015) "n-Values of commercial YBCO tapes before and after irradiation by fast neutrons" Supercond. Sci. Technol. 28 035008.

A preferred variant provides that the deposition of the first HTS material is done such that a fraction of deposited atoms does not find correct lattice sites during layer growth, and that this fraction is large enough such that it contributes to or results in concentration of pinning centers and said incomplete connectivity. Said fraction of atoms of the first HTS material that does not find its correct lattice site within the crystal structure of the first HTS material ("non-ordered atoms") introduces intrinsic disorder into the first HTS material, which is highly efficient in increasing the local critical current density in the first HTS material under low T, high B conditions. Introducing intrinsic disorder in this way is relatively simple, and in particular does not require multiple source materials or adding an additive substance (or its precursor or precursors) into a respective source material. Note that it is possible to introduce intrinsic disorder in this way also to the second HTS material in the second HTS layer, if desired.

In a preferred further development, a deposition speed for depositing the first HTS material is chosen high enough such that the layer of the first HTS material is grown with said fraction,
in particular wherein a deposition speed corresponding to a deposition thickness of 0.2 nm or more per deposition pulse in a pulsed laser deposition process is chosen. The high deposition speed (also called deposition rate) introduces intrinsic disorder into the first HTS material in a simple way. Note that applying a low substrate tape temperature promotes that atoms cannot find correct lattice sites of the HTS material. Further, a high deposition speed is promoted by choosing a short distance from a material source to the substrate tape. Note that in PLD (pulsed laser deposition), the characteristics of the laser plume also contribute significantly to the deposition speed.

Further preferred is a variant providing that depositing the first HTS material is done with multiple variations of one or more deposition parameters, in particular applying oxygen pressure pulses every 5-20 nm of layer thickness increase in a pulsed laser deposition process, causing local deviations of the stoichiometry of the first HTS material, and that the degree, in particular frequency and/or amplitude, of the multiple variations is chosen high enough such that these deviations in stoichiometry contribute to or result in concentration of pinning centers and said incomplete connectivity. The multiple parameter variations introduce intrinsic disorder into the first HTS material in a simple way, and may in particular be used when depositing the layer of the first HTS material and the layer of the second HTS material from the same one source material. Note that the deviations of the stoichiometry come along with deposited atoms not finding a correct lattice site ("non-ordered atoms", see above).

A particularly preferred variant provides
that the first HTS material is chosen with a local critical current density Jc^{1st/local}_{highT/lowB} at 77 K and at self magnetic field, and the second HTS material is chosen with a critical current density Jc^{2nd}_{highT/lowB} at 77 K and at self magnetic field, with
Jc^{1st/local}_{highT/lowB}^{∗}2≤Jc^{2nd}_{highT/lowB}, preferably Jc^{1st/local}_{highT/lowB}^{∗}4≤Jc^{2nd}_{highT/lowB}, and that the first HTS material is chosen with a local critical current density Jc^{1st/local}_{lowT/highB} at 4.2 K and at 18 Tesla, and the second HTS material is chosen with a critical current density Jc^{2nd}_{lowT/highB} at 4.2 K and at 18 Tesla, with Jc^{1st/local}_{lowT/highB}≥2^{∗}Jc^{2nd}_{lowT/highB}, preferably Jc^{1st/local}_{lowT/highB} ≥5 Jc^{2nd}_{lowT/highB}. With these characteristics, high overall critical currents of the HTS tape as a whole can be achieved, both at high T/low B and, more importantly, at low T/ high B conditions. The second HTS material generally does not shown significant differences between local and long distance critical current densities; however if necessary, Jc^{2nd}_{highT/lowB} and Jc^{2nd}_{lowT/highB} may be determined locally, too. Note that for measuring the characteristics of the first HTS material or the second HTS material alone, the respective material may be deposited separately (i.e. without the other material) as a test sample on a (buffered) substrate tape. Note that in general often Jc^{1st/local}_{lowT/highB} ≥10^{∗}Jc^{2nd}_{lowT/highB} applies.

Preferred is a variant wherein the layer of the first HTS material and the layer of the second HTS material are deposited directly on one another. This has been found to improve the current carrying capacity of the HTS tape as a whole significantly, in particular under low T, high B conditions.

In another preferred variant, at least a lower layer of the second HTS material and an upper layer of the second HTS material are deposited, and the layer of the first HTS material is deposited in between the lower layer and the upper layer of the second HTS material. In other words, the layer of the first HTS material is "sandwiched" between the layers of second HTS material. The second HTS material used in the upper (outer) layer will improve current transfer to the current electrodes, in particular at 77 K. Further, the presence of the second HTS material in the lower (inner) layer between the buffer layer and other HTS layers will (i) improve the texture of the total HTS system because texture can be better "transferred" through a layer with lower concentration of structural defects, and (ii) create an additional "bypassing" layer for the (more) inhomogeneous layer of the first HTS material.

In another advantageous variant, the first HTS material is deposited with a higher degree of intrinsic and extrinsic disorder as compared to the second HTS material. The incomplete connectivity on the first HTS material is achieved, in general and in accordance with the invention, by introducing high levels of intrinsic and/or extrinsic disorder. When introducing both substantial intrinsic and substantial extrinsic disorder according to this variant, a particularly high local critical current density Jc^{1st/local}_{lowT/highB} of the first HTS material as compared to Jc^{2nd}_{lowT/highB} of the second HTS material can be obtained, and therefore also a particularly high overall critical current density Jc^{All}_{lowT/highB} of the HTS tape at high magnetic field (18 Tesla) and low temperature (4.2 K) can be achieved. A higher degree of intrinsic disorder can be established for example by depositing the HTS material at a higher deposition rate and/or at a lower temperature and/or by applying a higher degree of deposition parameter variations (see above). A higher degree of extrinsic disorder can be established by depositing with a higher content of additional substance (see above).

In another preferred variant, the method includes intruding with second HTS material into the layer of the first HTS material,
in particular with a degree of intrusion into the layer of the first HTS material in thickness direction of at least 5%, preferably at least 20%, most preferably 100%. By mutual intrusion, the bridging effect of the second HTS material with respect to fragmented first HTS material substructures can be improved. Preferably, during the manufacturing of the HTS tape, second HTS material fills up gaps between fragmented first HTS material substructures from above. Note that the intrusion may be mechanically, chemically, or both. This implies that two materials can "penetrate" each other, either through the development of a ridge-valley interface relief, or through partial chemical diffusion of materials, or both. In particular, the layers of first HTS material and second HTS material may "merge" into each other by forming gradients of additive substance and/or non-ordered atom content and/or degree of stoichiometric deviations.

Further preferred is a variant wherein at least one buffer layer is deposited on the substrate tape, and at least the layer of the first HTS material and the layer of second HTS material are grown with an in-plane texture on the buffer layer. Applying the buffer layer and growing the HTS material with in-plane texture results in high critical current densities under both low T/high B and high T/low B conditions. Typical buffer materials for the invention are YSZ (yttria stabilized zirconia) and MgO. In case the method comprises depositing more layers of the first HTS material and/or the second HTS material, typical all these layers are grown with said in-plane texture.

### Inventive HTS tapes

Further within the scope of the present invention is a high temperature superconductor (=HTS) tape, comprising
at least a layer of a first HTS material and a layer of a second HTS material arranged on a substrate tape,
characterized in
that the layer of the first HTS material exhibits an incomplete connectivity with respect to said layer's superconducting electrical conductivity along the HTS tape length,
and that the layer of the second HTS material exhibits a continuous connectivity with respect to said layer's superconducting electrical conductivity along the HTS tape length.
With this type of HTS tape, a very high critical current transport capacity can be achieved under low T/high B conditions. Note that in general, also a satisfactory critical current transport capacity can be achieved under high T/low B conditions, too, so the HTS tape can be used universally under different conditions. Typically, the first HTS material has a higher degree of both intrinsic disorder and extrinsic disorder as compared to the second HTS material. An inventive HTS tape can be produced using the inventive method described above.

In a preferred embodiment of the inventive HTS tape, at least the layer of the first HTS material contains an additive substance of extrinsic origin, in particular BaZrO₃ at a concentration of 3 wt% or more, preferably 6 wt% or more. By means of the additive substance, extrinsic disorder can be introduced in the layer of the first HTS material. The content (concentration) of additive substance is high enough such that it contributes to or results in concentration of pinning centers and the incomplete connectivity. Extrinsic origin means that the additive material and the first HTS material are (chemically) different from each other and originate from different source materials (e.g. PLD targets) or different components within a source material (such as a PLD target). In general, the additive substance forms precipitates in the first HTS material. Wt% indicates percent in weight (or mass, respectively).

In an advantageous further development of this embodiment, the layer of the first HTS material is free from macro-scale structures of the additive substance, in particular of nano-rods of the additional substance. Then particularly high local critical current densities (and overall HTS tape superconducting current carrying capacities) can be achieved under low T/high B conditions.

In another advantageous embodiment, the layer of the first HTS material contains a fraction of atoms at incorrect lattice sites and/or local deviations of the stoichiometry of the first HTS material. By this means, disorder can be introduced in a simple way, namely intrinsic disorder. Introducing intrinsic disorder does not require a particular material source or sources. The fraction of "non-ordered atoms" is large enough and/or the degree of local deviations is high enough such that said fraction and/or said degree of local deviations contribute to or result in concentration of pinning centers and the incomplete connectivity.

Particularly preferred is an embodiment providing
that the first HTS material has a local critical current density Jc^{1st/local}_{highT/lowB} at 77 K and at self magnetic field, and the second HTS material has a critical current density Jc^{2nd}_{highT/lowB} at 77 K and at self magnetic field, with Jc^{1st/local}_{highT/lowB}*2≤Jc^{2nd}_{highT/lowB}, preferably Jc^{1st/local}_{highT/lowB}*4≤Jc^{2nd}_{highT/lowB}, and that the first HTS material has a local critical current density Jc^{1st/local}_{lowT/highB} at 4.2 K and at 18 Tesla, and the second HTS material has a critical current density Jc^{2nd}_{lowT/highB} at 4.2 K and at 18 Tesla, with Jc^{1st/local}_{lowT/highB}≥2*Jc^{2nd}_{lowT/highB}, preferably Jc^{1st/local}_{lowT/highB}≥5*Jc^{2nd}_{lowT/highB}. With these characteristics, high overall critical currents of the HTS tape as a whole can be achieved, both at high T/low B and, more importantly, at low T/high B conditions. The second HTS material generally does not shown significant differences between local and long distance critical current densities; however if necessary, Jc^{2nd}_{highT/lowB} and Jc^{2nd}_{lowT/highB} may be determined locally, too. Note that in general often Jc^{1st/local}_{lowT/highB} ≥10*Jc^{2nd}_{lowT/highB} applies.

Further preferred is an embodiment wherein the layer of the first HTS material and the layer of the second HTS material are arranged directly adjacent to one another. This has been found to improve the current carrying capacity of the HTS tape as a whole significantly.

Also preferred is an embodiment wherein the HTS tape comprises at least a lower layer of the second HTS material and an upper layer of the second HTS material, and the layer of the first HTS material is arranged between the lower layer and the upper layer of the second HTS material. In other words, the layer of the first HTS material is "sandwiched" between the layers of second HTS material. The second HTS material used in the upper (outer) layer will improve current transfer to the current electrodes, in particular at 77 K. Further, the presence of the second HTS material in the lower (inner) layer between the buffer layer and other HTS layers will (i) improve the texture of the whole HTS system because texture can be better "transferred" through a layer with lower concentration of structural defects, and (ii) create an additional "bypassing" layer for the (more) inhomogeneous layer of the first HTS material. Another preferred embodiment provides that the HTS tape comprises at least two layers of the first HTS material and at least two layers of the second HTS material, with layers of the first HTS material and the layers of the second HTS material arranged alternatingly in thickness direction. This improves the bridging effect of the second HTS material, and in particular may improve mutual intrusion of the HTS materials. Note that in general it is preferred to start on the buffer layer with a layer of the second HTS material, and/or to have a layer of the second HTS material as top HTS layer.

In a preferred embodiment, intrusions of the second HTS material reach into the layer of the first HTS material in thickness direction,
in particular with a degree of intrusion into the layer of the first HTS material in thickness direction of at least 5%, preferably at least 20%, most preferably 100%. The mutual intrusion improves the bridging effect of the second HTS material of continuous connectivity with respect to the incomplete connectivity of the first HTS material. A particular high degree (depth) of intrusion can be achieved for island-like layers of first HTS material.

Further preferred is an embodiment providing that the layer of first HTS material exhibits a filament structure having its filaments oriented along the tape length and comprising multiple filaments across the tape width. The filament structure may provide parallel current paths distributed across the tape width, improving the bridging effect with respect to the incomplete connectivity and improving the tolerance of the HTS tape to local macro-defects which are capable of blocking of the superconductive transport current through the filament.

Further advantages can be extracted from the description and the enclosed drawing. The features mentioned above and below can be used in accordance with the invention either individually or collectively in any combination. The embodiments mentioned are not to be understood as exhaustive enumeration but rather have exemplary character for the description of the invention.

### Drawing

The invention is shown in the drawing.
- Fig. 1: shows a schematic longitudinal section of an embodiment of an inventive HTS tape, having one layer of a first HTS material and one layer of a second HTS material arranged on top;
- Fig. 2: shows a schematic longitudinal section of an embodiment of an inventive HTS tape, having a lower layer and an upper layer of a second HTS material, and a layer of a first HTS material arranged in between, with illustrations of electric currents under high T/low B conditions;
- Fig. 3: shows the HTS tape of Fig. 2, with illustrations of electric currents under low T/high B conditions;
- Fig. 4: show a schematic top view of the HTS tape of Fig. 3, with illustrations of electric currents through the second HTS material bypassing a gap between first HTS material substructures in a filament column;
- Fig. 5: shows a schematic cross section of an embodiment of an HTS tape, having a lower layer and an upper layer of a second HTS material, and a layer of a first HTS material arranged in between, wherein the concentration of disorder is gradual in height (thickness) direction;
- Fig. 6: shown a diagram of the degree of double disorder in the HTS tape of Fig. 5 as a function of the coordinate in height direction;
- Fig. 7: shows a schematic view of an apparatus for producing an inventive HTS tape in accordance with the invention.
- Fig. 8: shows a schematic view of an alternative target unit used in an apparatus for producing an inventive HTS tape in accordance with the invention.

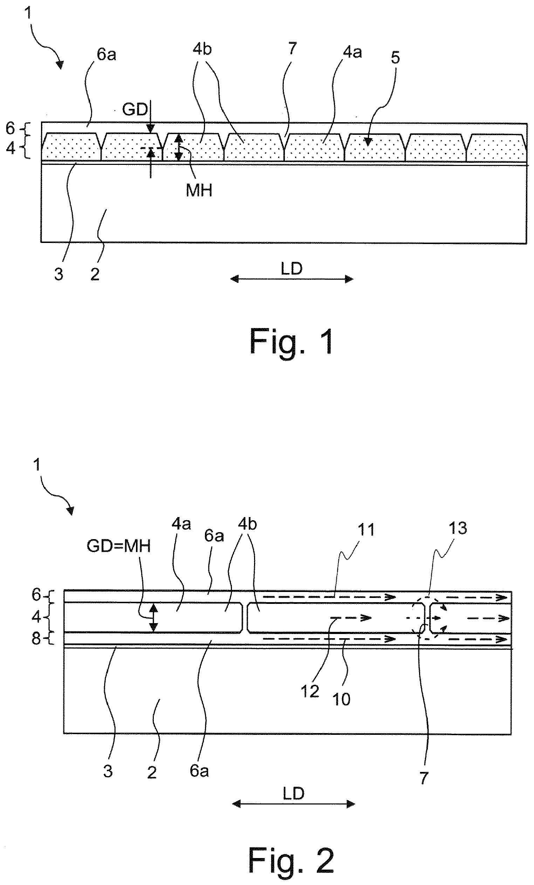

Fig. 1 shows an embodiment of an HTS tape 1 in accordance with the invention, in a schematic longitudinal view.

In the embodiment shown, a substrate 2 here made of stainless steel is covered with a buffer layer 3 here of MgO. On the buffer layer 3, there is deposited a layer 4 of a first HTS material 4a. The first HTS material 4a is here of YBCO type. Further, a layer 6 of a second HTS material 6a is deposited on top of the layer 4 of the first HTS material 4a. The second HTS material 6a is also of YBCO type here. The layers 4, 6 have an in-plane texture on the buffer layer 3.

During deposition of the first HTS material 4a, here also some additive substance 5 was been deposited concurrently, in the present example BaZrO₃ with a concentration of 6 wt%. Said additive substance 5 formed spot-like defects in the layer 4 here, indicated with a dotting, and introduced extrinsic disorder into the layer 4 of the first HTS material 4a. Further, during deposition of the first HTS material 4a, oxygen pressure pulses have been applied, which led to deviations in the stoichiometry in the YBCO crystals, and introduced intrinsic disorder into the layer 4 of the first HTS material 4a. It should be noted that other ways to introduce intrinsic disordered are possible, too.

Accordingly, the layer 4 of first HTS material 4a contains both significant extrinsic and significant intrinsic disorder, i.e. a "double disorder", what increased the local critical current density under low T, high B conditions, further what decreased the local critical current density under high T, low B conditions, and came along an incomplete connectivity with respect to the superconducting electrical conductivity along the tape length of this layer 4.

When the critical current density of the layer 4 is measured alone (e.g. before layer 6 has been deposited), the local critical current density Jc^{1st/local}_{lowT/highB} measured in long direction LD of the tape (which is from left to right in Fig. 1) along a distance of half the tape width (which is perpendicular to the drawing plane of Fig. 1) is much higher than the *long distance* critical current density Jc^{1st/longdist}_{lowT/highB} measured in long direction of the tape along a distance of 100 times the tape width, for example with Jc^{1st/local}_{lowT/highB} ≥ 5*Jc^{1st/longdist}_{lowT/highB} or even Jc^{1st/local}_{lowT/highB} ≥ 50*Jc^{1st/longdist} _{lowT/highB}. Note that the comparison is done at 4.2 K (low T) and at 18 Tesla (high B) conditions, but the ratio does not change much with variations of the temperature or of the magnetic field. In the example shown, the incomplete connectivity in layer 4 comes along with the formation of island-like substructures 4b in the layer 4 of the first HTS material 4, which probably impedes electric current from propagating in long direction LD superconductingly. In the example shown, on the upper side of layer 4, gaps 7 are formed between the substructures 4b. The gaps 7 have a depth GD in height direction (thickness direction, vertical in Fig. 1), which corresponds to about half of the maximum height MH of the layer 4.

On top of the layer 4 of the first HTS material 4a, the layer 6 of second HTS material 6a was deposited. The second HTS material 6a is free from additive substance here, and the deposition was done without oxygen pressure pulses. Accordingly, the layer 6 contains no extrinsic disorder, and only minimal intrinsic disorder, resulting in the layer 6 of second HTS material 6a showing a continuous connectivity with respect to the superconducting electrical conductivity along the tape length of this layer 6.

When the critical current density of the layer 6 is measured alone (e.g. in a test setup wherein only the layer 6 of second HTS material 6a is deposited on the buffer layer 3, not shown here), the local critical current density Jc^{2nd/local}_{lowT/highB} measured in long direction LD of the tape along a distance of half the tape width is about the same as the long distance critical current density Jc^{2nd/longdist}_{lowT/highB} measured in long direction LD of the tape along a distance of 100 times the tape width, for example with 0.83≤Jc^{2nd/local} _{lowT/highB}≤Jc^{2nd/longdist}_{lowT/highB} ≤ 1.2. Therefore, one may in general refer to a "general" second critical current density Jc^{2nd}_{lowT/highB}, without distinguishing between local and long distance.

It should be mentioned that in general, the local critical current density Jc^{1st/local}_{lowT/highB} of the first HTS material is much larger than the critical current density Jc^{2nd}_{lowT/highB} under low T, high B conditions, e.g. with Jc^{1st/local}_{lowT/highB}≥6*Jc^{2nd}_{lowT/highB}. Further it should be noted that in general, under high T, low B conditions at 77 K and at self magnetic field, the local critical current density Jc^{1st/local}_{highT/lowB} is much smaller than the critical current density Jc^{2nd}_{hight/lowB} of the second HTS material, e.g. with Jc^{1st/local}_{highT/lowB}*10≤Jc^{2nd}_{highT/lowB}.

During deposition of the second HTS material 6a, said second material 6a fills up the gaps 7 between the substructures 4b of the layer 4. In other words, the layer 4 of first HTS material 4a is infiltrated with second HTS material 6a. In the example shown, the gap depth GD corresponding to about half of the maximum height MH of the layer 4 becomes infiltrated with second HTS material 6a, resulting in a degree of intrusion of about GD/MH^{∗}100%=50% here.

The second HTS material 6a can act as superconducting bridging for electric currents that propagate in long direction LD of the HTS tape 1, and which have to change from a substructure 4b having a high local current carrying capacity under low T, high B conditions to a next such substructure 4b. Then the HTS tape 2 as a whole may exhibit a high long distance superconducting current carrying capacity under low T, high B conditions.

The flow of electric currents in accordance to the invention is further illustrated in the embodiment of a HTS tape 1 shown in **Figs. 2 through 4****.** Only the major differences to the embodiment of Fig. 1 are discussed in the following.

In the HTS tape of Fig. 2, on the buffer layer 3 deposited on the substrate 2, there is deposited a lower layer 8 and an upper layer 6, both of second HTS material 6a. A layer 4 of double disordered first HTS material 4a is arranged in between the lower and upper layer 8, 6; note that a dotting in the layer 4 for indicating of the additive substance is omitted here to simplify the illustration. Since the lower layer 8 of second HTS material 6a contains only a low degree of disorder, the overall texture of the HTS tape 1 will be improved; all layers 8, 6, 4 show an in-plane texture on the buffer layer 3.

In the example shown, the high level of extrinsic and intrinsic disorder in the layer 4 of first HTS material 4 led to incomplete connectivity coming along with the formation of separate substructures 4b in the layer 4, here with gaps 7 with a gap depth GD reaching through the full, maximum height MH of the layer 4, i.e. GD=MH here. The gaps 7 are filled with second HTS material 6a, and the degree of intrusion of the second HTS material 6a into the layer 4 of first HTS material 4a is GD/MH^{∗}100%=100% here.

Under high T, low B (at 77K and self magnetic field) conditions illustrated in Fig. 2, superconducting electrical currents 10, 11 in the lower and upper layer 8, 6 dominate the overall superconducting electric current flow in the HTS tape 1, and superconducting current 12 in the sandwiched layer 4 is comparably small. This is due to the higher critical current density Jc^{2nd}_{highT/lowB} in the second HTS material 6a as compared to the lower local critical current density Jc^{1st/local}_{highT/lowB} in the first HTS material 4. Note that even under these high T, low B conditions, the second HTS material 6a does some bridging of electric current flowing between neighboring substructures 4b of the first HTS material 4a in layer 4, compare the bridging currents 13, but this is of low importance for the overall tape performance.

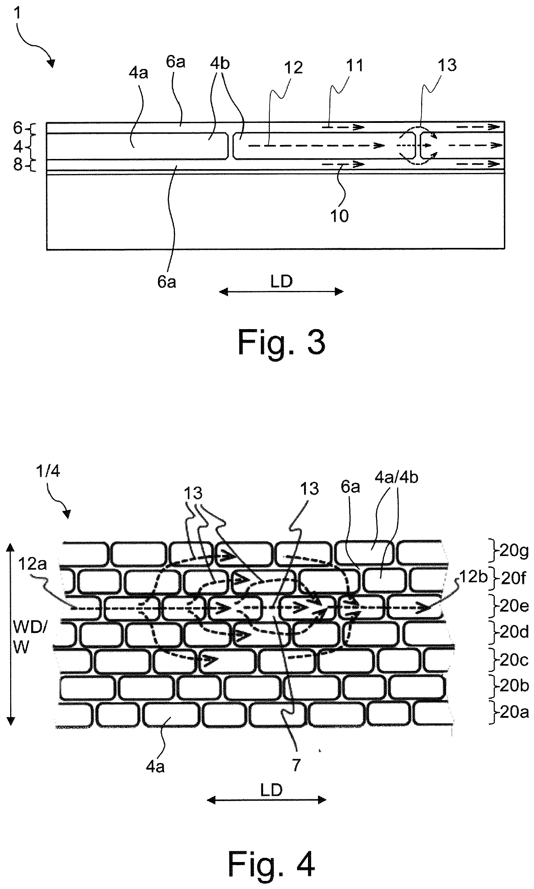

Under low T, high B (at 4.2 K and at 18 Tesla) conditions illustrated in Fig. 3, the superconducting electrical currents 10, 11 in the lower and upper layer 8, 6 are comparably small, and the superconducting current 12 in the sandwiched layer 4 dominates the overall superconducting electric current flow in the HTS tape 1. This is due to the higher local critical current density Jc^{1st/local}_{highT/lowB} in the first HTS material 4a as compared to the lower critical current density Jc^{2nd}_{highT/lowB} in the second HTS material 6a. Under the low T, high B conditions, the second HTS material 6a bridges electric current between neighboring substructures 4b of the first HTS material 4a in layer 4, making it possible to use the high Jc^{1st/local}_{highT/lowB} resulting from the double disorder in the first HTS material for the overall tape performance, compare the bridging currents 13.

It should be noted that bridging not only takes place immediately above and below a gap 7, but the bridging currents 13 may spread in the plane of the lower layer 8 and upper layer 6. In **Fig. 4****,** in a schematic top view, the island-like substructures 4b of the sandwiched layer 4 of first HTS material 4a are illustrated. The substructures 4b are grouped in filaments (or filament columns) 20a-20g here, which extend along the long direction LD of the HTS tape 1 and are arranged next to each other in width direction WD. Between the substructures 4b, second HTS material 6a has intruded. In the example shown, the HTS tape 1 has a width W, which is in practice typically about 2-20mm, often between 3 and 12 mm, and typically 4mm. The total length of a HTS tape 1 in long direction LD is typically 10m or more, often 100m or more.

For better understanding, one of the gaps 7 between two subsequent substructures 4b in filament 20e is shown enlarged. In order to allow electrical current 12a in filament 20e to "jump" over said gap 7 and to continue as electrical current 12b beyond the gap 7 in filament 20e, the bridging currents 13 not only spread over the gap 7 as such, but also spread over to the neighboring filaments 20c, 20d and 20f, 20g and back to the filament 20e. It should be noted that this spreading occurs both via the lower layer and the upper layer of second HTS material 6a, and may also include a take-over of electrical currents in substructures 4b of the first HTS material 4a in the neighboring filaments 20c, 20d, 20f, 20g. Since there are so many paths (and so much cross-section, respectively) for bridging currents 13 through the second HTS material 6a to jump the comparably small gap 7, the relatively low critical current density Jc^{2nd}_{lowT/highB} of the second HTS material 6a is not of consequence, and the overall current carrying capacity of the HTS tape 1 is dominated by the relatively high local critical current density Jc^{1st/local}_{lowT/highB} of the first HTS material 4a.

It should be noted that for a good bridging effect, gaps 7 of neighboring filaments 20a-20g should be displaced in long direction LD; the filamentary arrangement of the substructures 4b in layer 4, together with a random distribution of the gaps 7 in long direction LD results in an irregular structure in width direction WD of the HTS tape 1 that results in a good overall tape performance, and that is particularly robust against defects ("hot spots") in the HTS tape 1. When growing the layer 4 of first HTS material 4a with double disorder, such an irregular structure is in general assumed as a random one, and it can be promoted by suitable measures during film growth, for example an adequate substrate temperature and a sufficiently high content of additive substance in the first HTS material 4a.

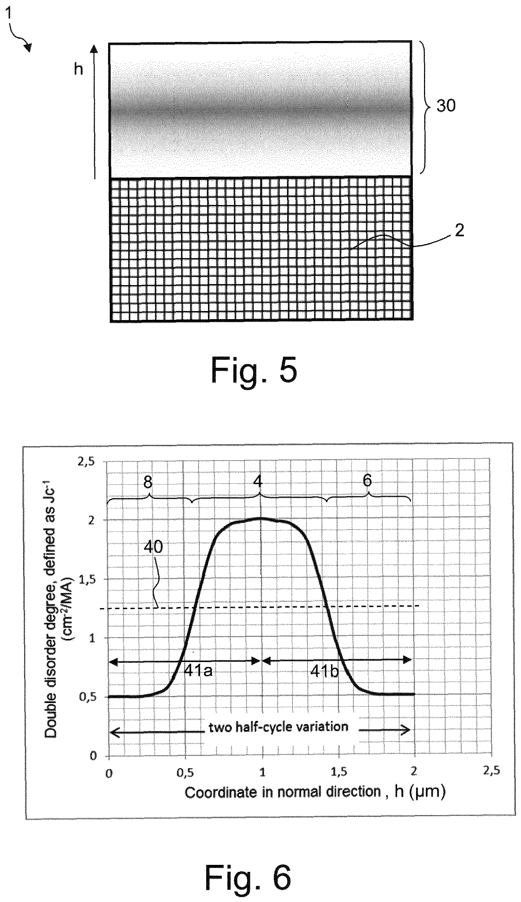

For the HTS tapes shown in Figs. 1 through 4, deposition characteristics are typically changed abruptly when a lower layer has been grown completely, and the next upper layer is grown, in order to provide for the desired degree of disorder in each layer. However, it is also possible to change the degree of disorder smoothly from layer to layer, resulting in disorder gradients in the HTS tape. In Fig. 5, in a cross-section of a HTS tape 1 in accordance with the invention, the HTS tape 1 comprises a substrate 2 and a zone 30 of deposited HTS material, wherein the degree of disorder is illustrated by the brightness. Light areas indicate a low degree of disorder, and dark areas indicate a high degree of disorder.

Fig. 6 shows in more detail in a diagram the degree of double disorder, expressed as the inverse critical current density 1/Jc of a respective HTS material layer at the designated height, as a function of the height coordinate h (i.e. in direction normal to the substrate plane) under high T, low B conditions. In the diagram, an average value 40 of 1/Jc is marked with dashed line. The two height intervals with 1/Jc values below the average value 40 can be considered as layers 8, 6 of second HTS material, and the height interval with 1/Jc values above the average value 40 can be considered as a the layer 4 of first HTS material. Note that layers may be determined analogously also with less or more height intervals resp. layers. Using graded double disorder, often particularly good tape performances, in particular superconducting current carrying capacities under low T, high B conditions may be achieved.

It should be noted that a graded HTS zone is typically produced in one or more "half cycles", in Fig. 6 two half cycles 41a, 41b, during which the double disorder is increased once or decreased once. The smooth (gradual) change in the double disorder concentration is achieved by smoothly (gradually) changing one or a plurality of deposition conditions or parameters. For example, during a half cycle, a distance of a target (source of material for deposition) to a substrate of the HTS tape may be changed during PLD, or the frequency of oxygen pressure pulses may be changed during the growth of the HTS tape. For changing the concentration of additive substance, during PLD, the laser beam may switch between two targets (typically with one target containing HTS material and additive substance, and one target containing "pure" HTS material), wherein the ratio of dwell times at the respective two targets change over time.

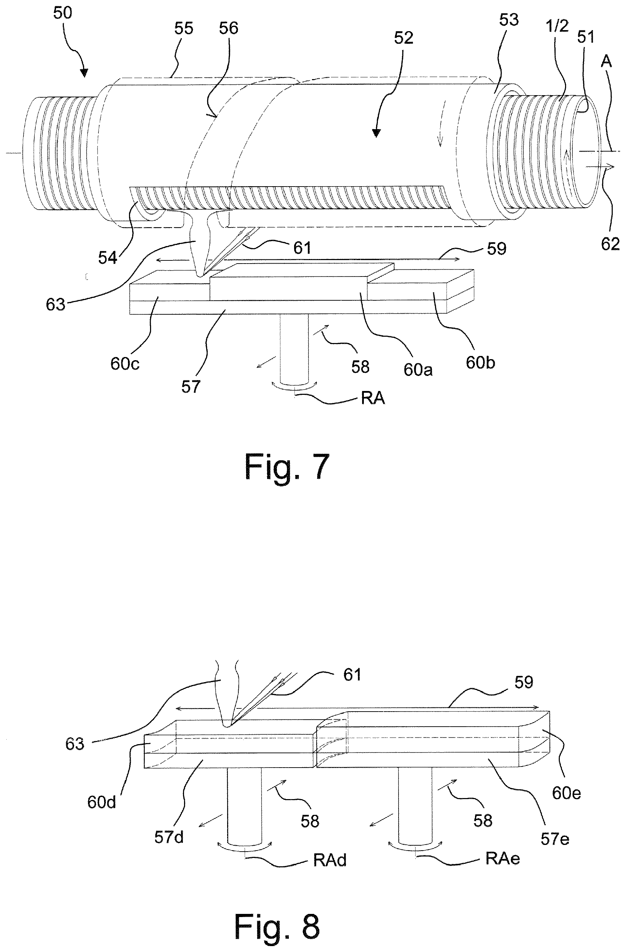

**Fig. 7** illustrates schematically an apparatus 50 for manufacturing a HTS tape 1 in accordance with the invention, here based on a PLD (pulsed laser deposition) process. In the apparatus 50, a substrate 2 for the HTS tape 1 is wound on a carrier cylinder 51, and the carrier cylinder may be moved along its axis A through a heater arrangement 52 in movement direction 62 (forward and back, if needed), and may rotate about its axis A, which is here horizontal. The heater arrangement 52 comprises an inner housing 53 (with a heating element inside) having a deposition window 54 and an outer chopper 55 (shown transparent with dashed lines, for better understanding) which may rotate about the inner housing 53, i.e. about axis A. The chopper 55 has a helical notch 56 for allowing trespassing of deposition material or a laser plume 63, respectively. Function of the quickly (e.g. at 3 Hz) rotating chopper 55 is to suppress the IR (infrared radiation) losses originating from the substrate 2 or tape 1, respectively: the chopper 55 provides an IR screening of the main part of the substrate 2 or tape 1, respectively, within the deposition window 54. A minor part of IR loss remains only in the area of the deposition window 54 overlapping with the helical notch 56 in the chopper 55.

Opposite to the deposition window 54, a target holder 57 is arranged, which may perform discrete rotation turns of 180° about a rotation axis RA, which is here almost vertical; note that in alternative embodiments, the rotation axis may be inclined with respect to the vertical plane, e.g. with an angle between 25° and 45°, preferably about 35° (not shown). The target holder 57 may be smoothly shifted here in orthogonal direction 58 perpendicular to the rotation axis RA in order to provide a smooth scan of the surface of the targets 60a, 60b, 60c with a laser beam 61 (or a plurality of laser beams). Further smoothening is provided by the linear motion 59 of the laser beam 61 across the targets 60a, 60b, 60c.

On the target holder 57, there are arranged the radially inner target 60a for depositing the layer of first HTS material on the substrate 2, and further the two radially outer targets 60b, 60c for depositing the layer or layers of second HTS material on the substrate 2. The target 60a contains here both HTS material, here YBCO, and additive substance, here BaZrO₃, whereas the targets 60b, 60c only contain HTS material, here YBCO. Further, target 60a is closer to the deposition window 54 or the substrate 2 as compared to the targets 60b, 60c, which promotes the introduction of "non-ordered" atoms and/or stoichiometric deviations in the deposited HTS material when target 60a is used, as compared to targets 60b, 60c. Accordingly, when using target 60a, both significant extrinsic and significant intrinsic disorder is introduced in the deposited (first) HTS material. On the other hand, if targets 60b or 60c are used, no extrinsic and only few intrinsic disorder is introduced into the deposited (second) HTS material. The laser beam or beams 61 hitting a target 60a, 60b, 60c generate the laser plume 63, containing atoms from the chosen target, in Fig. 7 currently target 60c.

In the preferred variant of manufacturing the HTS tape 1, the laser beam or beams 61 scan quickly over all targets 60a, 60b, 60c, so three deposition zones are established simultaneously which are arranged in a row along the axis A. The carrier cylinder 51, on which the substrate 2 is wound as a helix, is in quick rotation about the axis A, and further, the carrier cylinder 51 is slowly moved (translated) along axis A, here from left to right in movement direction 62. As a result, each section of the substrate tape 2 is exposed in temporal sequence initially to the deposition zone of target 60b for growing a bottom layer of second HTS material, then the deposition zone of target 60a for growing an intermediate layer of first HTS material, and finally to the deposition zone of target 60c, for growing a top layer of second HTS material. The bottom layer of second HTS material, the intermediate layer of first HTS material and the top layer of second HTS material are therefore grown simultaneously on the HTS tape 1. The complete HTS coating on HTS tape 1 may be grown in one translation ("one run") of the carrier cylinder 51 through the apparatus 50, without breaking the vacuum in the apparatus 50.

In order to coat a substrate (substrate tape) 2, the movements and rotations of the components of the apparatus 50 are synchronized appropriately, preferably using an electronic control unit (not shown in detail).

In an alternative embodiment (not shown), as compared to the apparatus shown in Fig. 7, the target holder may comprise only two targets, namely one target for the first HTS material and one target for the second HTS material, for depositing the HTS coating of the HTS tape in half cycles (compare Fig. 6 above); multiple half cycles may be deposited in multiple translations of the carrier cylinder through the apparatus then.

In a further alternative embodiment shown in **Fig. 8****,** a split target holder may be applied, again for depositing the HTS coating of a HTS tape 1 in one or a plurality of half cycles (compare Fig. 6 above). Fig. 8 illustrates only a target unit, which may be used in an apparatus as shown by way of example in Fig. 7.

In the embodiment of the target unit of Fig. 8, the target holder is split into two independent (separate) holders 57d and 57e, with each target holder 57d, 57e carrying only one target 60d, 60e, with one target 60d for deposition of the second HTS material and the other target 60e for deposition of the first HTS material, respectively. The laser beam or laser beams 61 scan the surfaces of the targets 60d, 60e in common in order to generate the laser plume 63 (in Fig. 8 currently at target 60d). Each target holder 57d, 57e may be translated along movement direction 58 for smoothing the deposition process. Further, similar to the embodiment shown in Fig. 7, each target holder 57d, 57e may periodically turn around its respective axis RAd, RAe after several cycles of (common) scanning of their surfaces with the laser beam 61 in order to achieve smooth target ablation. In order to enable such 180° turns by minimal distance between the targets 60d and 60e, targets 60d and 60e and their holders 57d and 57e are provided with complimentary curved shapes, with the shapes being circularly curved with respect to here axis RAe. The curved shapes allow for turning target 60e first by 90°, then turning target 60d by 180°, and, finally, for accomplishing turning of target 60e using a next 90° turn. In the resulting azimuthally inversed position of each target 60d, 60e, the deposition process is continued without considerable deviation of the deposition speeds. When depositing a layer of first HTS material and a layer of second HTS material only (corresponding to one half cycle), the complete two-material coating on the HTS tape 1 may be performed in one translation ("one run") of the carrier cylinder 51 through the apparatus 50 (compare Fig. 7); multiple half cycles may be deposited in multiple translations of the carrier cylinder through the apparatus again.

### List of reference signs

- 1: HTS tape
- 2: substrate/substrate tape
- 3: buffer layer
- 4: layer of first HTS material
- 4a: first HTS material
- 4b: substructure of layer of first HTS material
- 5: additive substance
- 6: layer of second HTS material
- 6a: second HTS material
- 7: gap
- 10: electric current (lower layer of second HTS material)
- 11: electric current (upper layer of second HTS material)
- 12: electric current (sandwiched layer of first HTS material)
- 12a: electric current (before gap)
- 12b: electric current (after gap)
- 13: bridging currents
- 20a-20g: filaments
- 30: (graded) zone of HTS material
- 40: average 1/Jc value
- 41a, 41b: half cycles
- 50: apparatus
- 51: carrier cylinder
- 52: heater arrangement
- 53: inner housing
- 54: deposition window
- 55: chopper
- 56: notch
- 57: target holder
- 57d: target holder of the target (for second HTS material deposition)
- 57e: target holder of the target (for first HTS material deposition)
- 58: movement direction
- 59: movement direction
- 60a: target (for first HTS material deposition)
- 60b, 60c: target (for second HTS material deposition)
- 60d: target (for second HTS material deposition)
- 60e: target (for first HTS material deposition)
- 61: laser beam
- 62: movement direction
- A: axis (carrier cylinder)
- Jc: critical current density
- GD: gap depth
- h: height/thickness direction/coordinate
- LD: long direction
- MH: maximum height (layer of first HTS material)
- RA: rotation axis
- RAd: rotation axis of the target for second HTS material deposition
- RAe: rotation axis of the target for first HTS material deposition
- W: tape width
- WD: width direction

## Claims

1. A method for manufacturing a high temperature superconductor (=HTS) tape (1), comprising
depositing at least a layer (4) of a first HTS material (4a) and a layer (6, 8) of a second HTS material (6a) on a substrate tape (2),
**characterized in**
**that** the first HTS material (4a) is deposited with the layer (4) of the first HTS material (4a) exhibiting an incomplete connectivity with respect to said layer's superconducting electrical conductivity along the HTS tape (1) length,
and **that** the second HTS material (6a) is deposited such that the layer (6, 8) of the second HTS material (6a) exhibits a continuous connectivity with respect to said layer's superconducting electrical conductivity along the HTS tape (1) length.

2. Method according to claim 1, **characterized in that** at least the first HTS material (4a) is deposited with a content of an additive substance (5), and the content of the additive substance (5) in the first HTS material (4a) is chosen high level such that it contributes to or results in concentration of pinning centers and said incomplete connectivity.

3. Method according to claim 2, **characterized in that** depositing of the first HTS material (4a) is done with suppressing the formation of macro-scale structures of the additive substance (5), in particular of nano-rods of the additive substance (5), within the layer (4) of the first HTS material (4a).

4. Method according to one of the preceding claims, **characterized in that** the deposition of the first HTS material (4a) is done such that a fraction of deposited atoms does not find correct lattice sites during layer growth, and that this fraction is large enough such that it contributes to or results in concentration of pinning centers and said incomplete connectivity.

5. Method according to claim 4, **characterized in that** that a deposition speed for depositing the first HTS material (4a) is chosen high enough such that the layer (4) of the first HTS material (4a) is grown with said fraction, in particular wherein a deposition speed corresponding to a deposition thickness of 0.2 nm or more per deposition pulse in a pulsed laser deposition process is chosen.

6. Method according to one of the preceding claims, **characterized in that** depositing the first HTS material (4a) is done with multiple variations of one or more deposition parameters, in particular applying oxygen pressure pulses every 5-20 nm of layer thickness increase in a pulsed laser deposition process, causing local deviations of the stoichiometry of the first HTS material (4a), and that the degree, in particular frequency and/or amplitude, of the multiple variations is chosen high enough such that these deviations in stoichiometry contribute to or result in concentration of pinning centers and said incomplete connectivity.

7. Method according to one of the preceding claims, **characterized in**
**that** the first HTS material (4a) is chosen with a local critical current density Jc^{1st/local}_{highT/lowB} at 77 K and at self magnetic field, and the second HTS material (6a) is chosen with a critical current density Jc^{2nd}_{highT/lowB} at 77 K and at self magnetic field, with Jc^{1st/local}_{highT/lowB}*2≤Jc^{2nd}_{highT/lowB}, preferably Jc^{1st/local}_{highT/lowB}*4≤Jc^{2nd}_{highT/lowB}, and that the first HTS material (4a) is chosen with a local critical current density Jc^{1st/local}_{lowT/highB} at 4.2 K and at 18 Tesla, and the second HTS material (6a) is chosen with a critical current density Jc^{2nd}_{lowT/highB} at 4.2 K and at 18 Tesla, with Jc^{1st/local}_{lowT/highB}≥2*Jc^{2nd}_{lowT/highB}, preferably Jc^{1st/local}_{lowT/highB}>5*Jc^{2nd}_{lowT/highB}.

8. Method according to one of the preceding claims, **characterized in that** at least a lower layer (8) of the second HTS material (6a) and an upper layer (6) of the second HTS material (6a) are deposited, and the layer (4) of the first HTS material (4a) is deposited in between the lower layer (8) and the upper layer (6) of the second HTS material (6a).

9. Method according to one of the preceding claims, **characterized in that** the first HTS material (4a) is deposited with a higher degree of intrinsic and extrinsic disorder as compared to the second HTS material (6a).

10. Method according to one of the preceding claims, **characterized in that** at least one buffer layer (3) is deposited on the substrate tape (2), and at least the layer (4) of the first HTS material (4a) and the layer (6, 8) of second HTS material (6a) are grown with an in-plane texture on the buffer layer.

11. A high temperature superconductor (=HTS) tape (1), comprising at least a layer (4) of a first HTS material (4a) and a layer (6, 8) of a second HTS material (6a) arranged on a substrate tape (2),
**characterized in**
**that** the layer (4) of the first HTS material (4a) exhibits an incomplete connectivity with respect to said layer's superconducting electrical conductivity along the HTS tape (1) length,
and **that** the layer (6, 8) of the second HTS material (6a) exhibits a continuous connectivity with respect to said layer's superconducting electrical conductivity along the HTS tape (1) length.

12. A HTS tape (1) according to claim 11, **characterized in that** at least the layer (4) of the first HTS material (4a) contains an additive substance of extrinsic origin, in particular BaZrO₃ at a concentration of 3 wt% or more, preferably 6 wt% or more.

13. A HTS tape according to claim 12, **characterized in that** the layer (4) of the first HTS material (4a) is free from macro-scale structures of the additive substance (5), in particular of nano-rods of the additional substance (5).

14. A HTS tape (1) according to any one of the claims 11 through 13, **characterized in that** the layer (4) of the first HTS material (4a) contains a fraction of atoms at incorrect lattice sites and/or local deviations of the stoichiometry of the first HTS material (4a).

15. A HTS tape (1) according to one of the claims 11 through 14, **characterized in**
**that** the first HTS material (4a) has a local critical current density Jc^{1st/local}_{highT/lowB} at 77 K and at self magnetic field, and the second HTS material (6a) has a critical current density Jc^{2nd}_{highT/lowB} at 77 K and at self magnetic field, with Jc^{1st/local}_{highT/lowB}*2≤Jc^{2nd}_{highT/lowB}, preferably Jc^{1st/local}_{highT/lowB}*4≤Jc^{2nd}_{highT/lowB}, and that the first HTS material (4a) has a local critical current density Jc^{1st/local}_{lowT/highB} at 4.2 K and at 18 Tesla, and the second HTS material (6a) has a critical current density Jc^{2nd}_{lowT/highB} at 4.2 K and at 18 Tesla, with Jc^{1st/local}_{lowT/highB}≥2*Jc^{2nd}_{lowT/highB}, preferably Jc^{1st/local}_{lowT/highB} ≥5*Jc^{2nd}_{lowT/highB}.

16. A HTS tape (1) according to one of the claims 11 through 15, **characterized in that** the layer (4) of the first HTS material (4a) and the layer (6, 8) of the second HTS material (6a) are arranged directly adjacent to one another.

17. A HTS tape (1) according to one of the claims 11 through 16, **characterized in that** the HTS tape (1) comprises at least a lower layer (8) of the second HTS material (6a) and an upper layer (6) of the second HTS material (6a), and the layer (4) of the first HTS material (4a) is arranged between the lower layer (8) and the upper layer (6) of the second HTS material (6a).

18. A HTS tape (1) according to one of the claims 11 through 17, **characterized in that** intrusions of the second HTS material (6a) reach into the layer (4) of the first HTS material (4) in thickness direction (h),
in particular with a degree of intrusion into the layer (4) of the first HTS material (4a) in thickness direction (h) of at least 5%, preferably at least 20%, most preferably 100%.

19. A HTS tape (1) according to one the claims 11 through 18, **characterized in that** the layer (4) of first HTS material (4a) exhibits a filament structure having its filaments (20a-20g) oriented along the tape length and comprising multiple filaments (20a-20g) across the tape width.
